# EUROPEAN PATENT APPLICATION

(11) **EP 1 420 511 A1**
(43) Date of publication of application: **19.05.2004**
(21) Application number: 03026075.6
(22) Date of filing: 12.11.2003
(51) Int. Cl.: H03D 3/24, H03L 7/00, H04B 10/00, H04L 7/033, H04B 10/14, H03K 19/21, H04L 25/06, H03D 3/00, H03F 3/08

(54) **Phase detector for extended linear response and highspeed data regeneration**

(30) Priority: 12.11.2002 US 293163
(71) Applicant: Broadcom Corporation, Irvine, California 92618-7013 (US)
(72) Inventor: Cao, Jun, Irvine California 92620 (US)
(74) Representative: Jehle, Volker Armin, Dipl.-Ing.

(57) **Abstract**

Methods and circuits for phase detectors having extended linear and monotonic ranges of operation. Phase detectors consistent with the present invention include a REFERENCE output that has improved immunity to the timing relationship between data input and clock signals. This improved immunity results in extended linear and monotonic ranges of operations.

## Description

### CROSS-REFERENCES TO RELATED APPLICATIONS

This application is related to commonly assigned, copending United States patent application number 10/ , , filed , 2002, titled Phase Detector With Delay Elements for Improved Data Regeneration, by Cao et al., which is incorporated by reference.

### BACKGROUND

The present invention relates generally to phase detectors, and more specifically to phase detectors having an extended linear response.

Data networking has exploded over the last several years and has changed the way people work, get information, and spend leisure time. Local area networks at the office allow for centralized file sharing and archiving. Mobile phones allow users access to news updates and stock quotes. The Internet has transformed shopping and has spawned a new recreational activity―web surfing. Many computers are used primarily as interfaces to these networks; thus the expression "the network is the computer" has been coined.

Devices such as network interface cards (NICs), bridges, routers, switches, and hubs move data between users, between users and servers, or between servers. Data moves over a variety of media such as fiber optic or twisted pair cables and the air. These media distort data, making it difficult to be read. Lightwaves traveling in a fiber optic cable reflect at the core-cladding interface and disperse. Twisted pair cables filter higher frequencies. Wireless signals bounce off surfaces in a phenomenon known as multipath, smudging one data bit into the next.

Accordingly, these devices, NICs, bridges, routers, switches, and hubs, receive distorted data and clean it up - or retime it - for use either by the device itself or for retransmission. A useful building block for this is the clock and data recovery (CDR) circuit. CDRs accept distorted data and provide a clock signal and retimed (or recovered) data as outputs.

Data is typically recovered by generating a clock signal at a frequency matching that of an incoming data stream. Active edges of this clock signal are aligned to an averaged center of the data stream, a process referred to as window centering. The clock is used to sample or recover the individual data bits. This results in optimal data recovery when the data is distorted in a symmetrical manner. But this distortion is not always symmetrical. In this case, the active clock edges may be phase shifted to improve performance. In practical phase detectors, these edges may only be shifted over a portion of the detectors operation, specifically, where the detector's operation is linear, or at least monotonic. Thus, what is needed is a phase detector having an extended linear response, that is, an extended linear range of operation.

### SUMMARY

Accordingly, embodiments of the present intervention provide methods and circuits for phase detectors having extended linear and monotonic ranges of operation. Specifically, phase detectors consistent with the present invention include a REFERENCE output that has improved immunity to the timing relationship between the input data and clock signal. This improved immunity results in extended linear and monotonic ranges of operations.

An exemplary embodiment of the present invention provides a method of recovering data from a data signal. This method includes receiving a clock signal having a first clock frequency, and alternating between a first level and a second level, receiving the data signal having a first data rate, the first data rate being substantially equal to the first clock frequency, providing a first signal by storing the data signal when the clock signal alternates from the first level to the second level, and providing a second signal by passing the first signal when the clock signal is at the first level, and storing the first signal when the clock signal is at the second level. The method further provides providing a third signal by storing the second signal when the clock signal is at the first level, and passing the second signal when the clock signal is at the second level, providing a fourth signal by delaying the data signal an amount of time, providing an error signal by combining the first signal and the fourth signal and providing a reference signal by combining the second signal and the third signal.

A further exemplary embodiment of the present invention provides a phase detector for recovering data from a data signal. The phase detector includes a first storage device configured to receive and store the data signal and to generate a first signal, a second storage device configured to receive and store the first signal and to generate a second signal, a third storage device configured to receive and store the second signal and to generate a third signal, and a delay block configured to receive and delay the data signal and to generate a fourth signal. Also included are a first logic circuit configured to combine the first and fourth signals, and a second logic circuit configured to combine the second and third signals.

Yet a further exemplary embodiment of the present invention provides a phase detector for recovering data from a received data signal. This phase detector provides a flip-flop having a data input coupled to a data input port, and a clock input coupled to a clock port, a first latch having a data input coupled an output of the first flip-flop, and a clock input coupled to the clock port, a second latch having a data input coupled to an output of the first latch, and a clock input coupled to the clock port, and a delay element having an input coupled to the data input port. Also included are a first logic circuit having a first input coupled to the output of the flip-flop and a second input coupled to an output of the delay element, and a second logic circuit having a first input coupled to the output of the first latch and a second input coupled to an output of the second latch.

A better understanding of the nature and advantages of the present invention may be gained with reference to the following detailed description and the accompanying drawings.

### BRIEF DESCRIPTION OF THE DRAWINGS

Figure 1 is a block diagram of an exemplary optical transceiver that may incorporate an embodiment of the present invention;

Figure 2 is a block diagram of a clock and data recovery circuit consistent with an embodiment of the present invention;

Figure 3 is a plot illustrating the difference voltage between the ERROR and REFERENCE signals for a conventional linear phase detector as a function of a phase difference between a reference clock and VCO clock signal;

Figure 4 is a block diagram of a phase detector consistent with an embodiment of the present invention;

Figure 5 is a generalized timing diagram of signals in a phase detector consistent with one embodiment of the present invention;

Figure 6 is a timing diagram of an embodiment of the present invention showing two specific data transitions;

Figure 7 is a generalized timing diagram of signals in a phase detector consistent with an embodiment of the present invention where the input data is delayed, or late, relative to the clock;

Figure 8 shows the timing of Figure 7 for two specific DATA transitions;

Figure 9 is a generalized timing diagram of signals in a phase detector consistent with one embodiment of the present invention where the data is advanced, or early, relative to the clock signal;

Figure 10 shows the timing of Figure 9 for two specific DATA transitions;

Figure 11 graphs the ERROR voltage and REFERENCE voltage outputs for a phase detector consistent with an embodiment of the present invention;

Figure 12 is a schematic for an exemplary implementation of a negative-edge triggered flip-flop that may be used as the flip-flop in Figure 4;

Figure 13 is a schematic of a latch that may be used as one or more of the latches in Figure 4;

Figure 14 and is an exemplary high speed XOR gate that may be used as one or more of the XOR gates in Figure 4; and

Figure 15 is a schematic of an exemplary circuit implementation for a delay element that may be used as the delay element in Figure 4.

### DESCRIPTION OF EXEMPLARY EMBODIMENTS

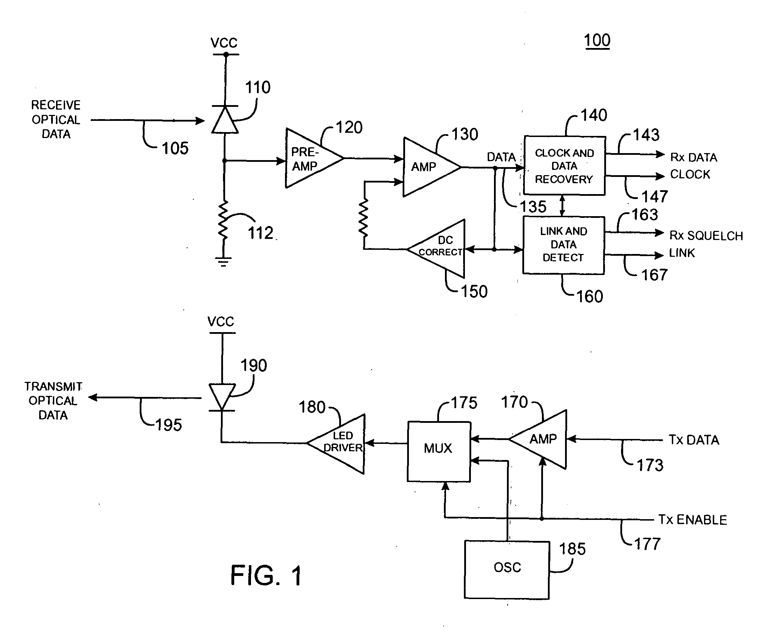

Figure 1 is an exemplary block diagram of an optical transceiver that may benefit by incorporating an embodiment of the present invention. This figure, as with all the included figures, is shown for illustrative purposes only and does not limit either the possible applications of the present invention or the appended claims. This optical transceiver may be on a NIC with a media access controller, some memory, and other circuits, or it may be in a hub, router, switch, or other piece of equipment.

Shown is a receive path including a photo diode 110, sensing resistor 112, pre-amplifier 120, amplifier 130, DC offset correction circuit 150, clock and data recovery circuit 140, and link and data detect 160. A transmit path includes an amplifier 170, light emitting diode (LED) driver 180, multiplexer 175, oscillator 185, and LED 190. Instead of the LED driver 180 and LED 190, the optical transmitting subsystem may alternately include a laser driver and laser diode.

A receive fiber optic cable 105 carries an optical data signal to the reversed-biased photo diode 110. Photo diode 110 senses the amount of light from fiber optic cable 105 and a proportional leakage current flows from the device's cathode to anode. This current flows though sense resistor 112, and generates a voltage. This voltage is amplified by pre-amplifier 120 and amplifier 130. Offsets are reduced by DC correction circuit 150. The output of amplifier 130 drives the clock and data recovery circuit 140, as well as the link and data detect block 160. The clock and data recovery circuits extract the clock signal embedded in the data provided on line 135 by the amplifier and with it retimes the data for output on lines 143. If the link and data detect block 160 senses either a data or link signal at the data line 135, a valid link signal is asserted on line 167. When the link and data detect block 160 senses a data signal at the data line 135, a receive squelch signal is de-asserted on line 163.

Transmit data is provided on line 173 to amplifier 170. Amplifier 170 is enabled or disabled by the transmit enable signal on line 177. When amplifier 170 is enabled, transmit data is passed to the multiplexer 175. Multiplexer 175 passes the transmit data to the LED driver 180, which in turn generates a current through LED 190. When current is driven through LED 190, light is emitted and transmitted on fiber optic cable 195. When the LED driver 180 is not driving current though LED 190, the LED is off, and the fiber optic cable 195 is dark. If the amplifier 170 is disabled, multiplexer 175 selects the idle signal from oscillator block 185. Oscillator block 185 provides an idle signal through the multiplexer 175 to the LED driver 180. This idle signal is used by a remote receiver to ensure that a valid optical connection has been made at both ends of the fiber-optic cable 105.

Again, the fiber optic media's physical limitations distort the received signal. Moreover, the delay through the amplifier 170, multiplexer 175, LED driver 180, and LED 190 may not be the same for light-to-dark and dark-to-light transitions. This mismatch causes duty cycle distortion. Further, transistor thermal noise and electrical noise in the power supply and data path generate jitter and phase noise, thus the delay through the transmitter changes as a function of time. Clock and data recovery circuits, such as block 140, retime data so it is in a more useable form for further processing, and provide a clock synchronized to the retimed data.

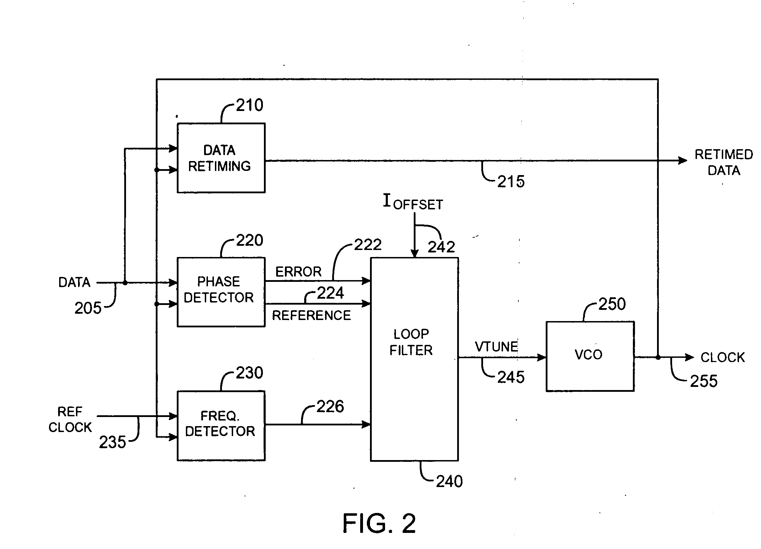

Figure 2 is a simplified block diagram of a clock and data recovery circuit or phase-locked loop consistent with an embodiment of the present invention. This architecture is shown for exemplary purposes, and does not limit either the possible applications of the present invention or the appended claims.

Included are retiming block 210, phase detector 220, frequency detector 230, loop filter 240, and VCO 250. Other architectures will be readily apparent to those skilled in the art. For example, in a specific embodiment, retiming block 210 is included in phase detector 220. Further, phase detector 220 and frequency detector 230 may be the same circuit, possibly under the control of a mode switch.

At startup, the loop adjusts the VCO 250 frequency. Startup may be initiated by the power supply turning on, by the reception of a valid link by the receiver, or other appropriate event. A reference clock is provided on lines 235 to the frequency detector 230. The reference clock is often a comparatively low-frequency signal generated by a stable oscillation source, for example a crystal. The output of the VCO 250, the CLOCK signal on lines 255, is typically divided down by an integral value and compared to the reference clock by the frequency detector 230. The CLOCK signal may be single-ended or differential. If the CLOCK signal is single-ended, lines 255 are simply one line. Frequency detector 230 provides an output signal on line 226 that is filtered by loop filter 240 and provided to VCO 250 as tuning voltage VTUNE 245. If the frequency of the CLOCK signal on lines 255 is too high, the frequency detector 230 changes its output voltage on line 226, and thus VTUNE on line 245, in such a direction as to lower the CLOCK signal's frequency. Conversely, if the CLOCK signal on lines 255 is too low in frequency, the frequency detector 230 changes its output voltage on line 226, and thus VTUNE on lined 245, in such a direction as to raise the CLOCK signal's frequency.

Once the CLOCK signal on lines 255 is tuned to the correct frequency, the phase detector 220 becomes active, and the frequency detector 230 becomes inactive. It may be determined that the clock signal is at the right frequency by monitoring Vtune, by the passage of a predetermined amount of time, by another event or combination of these events. A DATA signal on line 205 is received by the data retiming block 210 and phase detector 220 on lines 205. The DATA signal may be single-ended or differential. If the DATA signal is single-ended, line 205 is simply one line. Phase detector 220 compares transitions in the DATA signal on lines 205 to the rising edges of the CLOCK signal on lines 255, and produces an ERROR signal on line 222 that is proportional to the phase relationship between them. Alternately, the phase detector 220 can be designed so that the transitions in the DATA signal are compared to the falling edges of the CLOCK signal. The ERROR signal may be single-ended or differential. If the ERROR signal is single-ended, lines 222 are simply one line. Phase detector 220 also produces a REFERENCE signal on line 224 that can be subtracted from the ERROR signal to generate a data pattern independent correction signal. The REFERENCE signal may be single-ended or differential. If the REFERENCE signal is single-ended, lines 224 are simply one line. The ERROR and REFERENCE signals are subtracted and filtered by the loop filter 240 resulting in a voltage VTUNE 245.

As its name implies, the voltage controlled oscillator is an oscillator, the frequency of which is controlled by a voltage, in this example VTUNE. As VTUNE changes, the oscillation frequency changes. If the DATA signal on lines 205 and the CLOCK signal on lines 255 do not have the desired phase relationship, the error voltage, and thus VTUNE, changes in the direction necessary to adjust the VCO in order to correct the phase error. In a specific embodiment, if the DATA signal on lines 205 comes too soon, that is, it is advanced in time relative to the CLOCK signal on lines 255, the phase detector increases the ERROR voltage on line 222. This results in a change in the VTUNE voltage 245 that increases the frequency of the CLOCK 255. As the frequency of the CLOCK signal on lines 255 increases, its edges come sooner in time, that is they advance. This in turn, brings the clock's rising edges into alignment with transitions in the data signal on lines 205. As the edges move into alignment, the error signal on line 222 reduces, changing VTUNE 245, thereby reducing the frequency of the CLOCK signal on lines 255. This feedback insurers that the DATA and CLOCK signals have the proper phase relationship for retiming the data by retiming block 210. In this condition the loop is said to be locked. Hence, these clock and data recovery circuits are referred to as phase-locked loops.

The ERROR signal on line 222 and the REFERENCE signal on line 224 provide a relatively low frequency, essentially differential, correction signal. This has several important benefits. For example, the use of a REFERENCE signal gives context to the ERROR signal, reducing the data dependent phase errors that would otherwise result. If there are no data transitions this loop has no ERROR or REFERENCE signal information to lock to, but since there is no data to recover, this special case is of no interest.

Also, conventional systems often employ what is known as a "bang-bang" phase detector. In bang-bang detectors, for each data edge, depending on its relation to the clock, a charge-up or charge-down signal is sent to a charge pump. Such detectors alternate between advancing and delaying the clock signal from the VCO but never reach a stable point. Accordingly, bang-bang detectors have a certain amount of systematic jitter. Moreover, these pulses have fast edges containing high frequency components that couple to the supply voltage and inject noise into other circuits. Reducing this noise requires either filtering or using separate supply lines decoupled from each other. By using a low frequency, effectively differential signal out, the linear full-rate phase detector of the present invention does not have this systematic jitter and does not disturb the power supply and other circuits to the same extent.

When the CDR is locked, the net current charging the loop filter is zero, and typically, the data is centered on the active edges of the clock signal from the VCO. An offset current Ioffset on line 242 may be applied to the loop filter while the phase-locked loop is tracking data on the data line 205. For the loop filter net charging current to remain zero, the offset current is cancelled by a non-zero input from the phase detector resulting from a phase offset between the incoming data and clock signals. Accordingly, phase relationship between the DATA signal on line 205 and the CLOCK signal on line 255 may be adjusted by varying the magnitude and polarity of the offset current Ioffset 242.

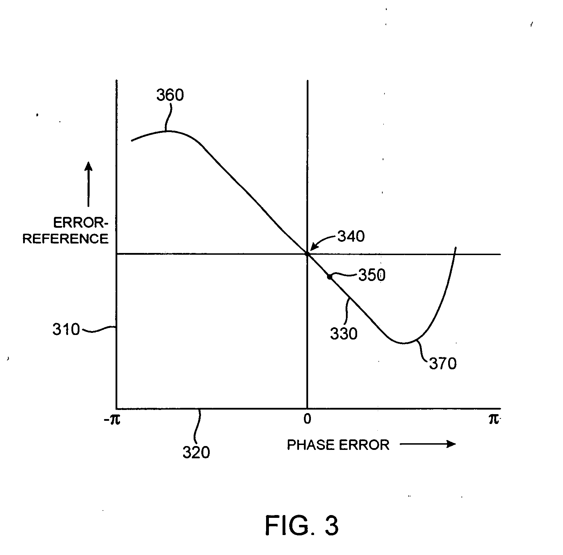

Figure 3 is a plot illustrating the difference voltage between the ERROR and REFERENCE signals for a conventional linear phase detector as a function of a phase difference between a reference clock and VCO clock signal. The difference voltage between the ERROR and REFERENCE signals, the gain of the phase detector, is plotted as curve 330 along a Y-axis 310 as a function of the phase error between the received data and clock signal from the VCO on X-axis 320.

As can be seen, the phase detector operates over a monotonic range between inflection points 360 and 370. Typically, when the loop is a locked, the phase detector operates at or near a zero phase error at point 340. Again, an offset current may be applied to the charge pump or loop filter in the phase locked loop, thus shifting the operating point from a zero phase error, for example to point 350.

As the phase error increases beyond inflection point 370, the phase detector is no longer monotonic, and the phase detector no longer provides an output signal that properly tracks the input data signal phase error. Specifically, the gain of the phase detector is reversed, and the detector no longer operates to adjust the VCO to provide a clock with a minimum (or desired) phase error.

One reason that the phase detector gain curve changes direction at the inflection point 370 is that phase detectors are realized using flip-flops. As the phase error increases, the setup time at a flip-flop having the data signal as its D input and the VCO signal as its clock reduces. This reduced setup time means that the signal level at the input stage of the flip-flop is reduced. This lower amplitude increases the clock-to-Q delay for the flip-flop, resulting in a skewing of the value of the error and reference signals. This may be referred to as amplitude modulation-phase modulation (AM/PM). A similar effect is seen for phase errors beyond point 360. The difference voltage between the error and reference signals may flatten, or reverse directions, beyond points 360 and 370, depending on exact circuit implementation.

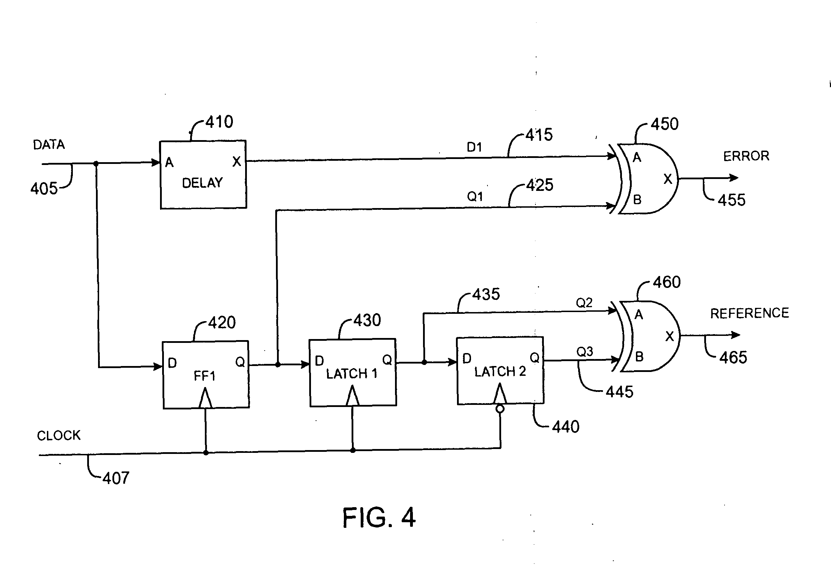

Figure 4 is a block diagram of a phase detector consistent with an embodiment of the present invention. This phase detector may be used as the phase detector 220 in Figure 2. Alternately, it may be used as the phase detector in other CDR architectures. For example, it may be used in an architecture having a charge pump between the phase detector and loop filter. The phase detector shown may be used in a CDR in a fiber optic transceiver, as shown in Figure 1. Alternately, it may be used in a CDR in other systems. CDRs are particularly important where a data processing system interfaces with a physical medium. Accordingly, this phase detector may be used in CDRs in twisted pair or coaxial transceivers, disk-drive or other mass-storage read channels, wireless receivers, routers, NICs, bridges, switches, hubs, and other electronic devices, circuits, and systems.

Included are a delay element 410, flip-flop 420, first latch 430, second latch 440, and exclusive-OR (XOR) gates 450 and 460. In a specific embodiment, the flip-flop 420 is a negative-edge triggered device. That is, flip-flop 420 changes state on falling edges of the clock signal. Latches 430 and 440 pass data when their clock input is high and latch data when their clock input is low. With this configuration the phase detector aligns the data centers to clock falling edges. If no offset current Ioffset 242 is applied, the falling edges of the clock are centered in the (averaged) middle of the incoming data bits. This "window centering" ensures that as the data eye closes due to noise, jitter, and the like, data recovery remains optimum, given a symmetrical distortion pattern. In other embodiments, a positive-edge triggered flip-flop may be used, and the latches may pass data when their clock inputs are low. In this alternate configuration, the phase detector aligns the centers of the data bits to the clock rising edges. Again, in either configuration, if an offset current Ioffset 242, or similar current is applied to the loop feature or charge pump, the edges shift relative to the center of the average data bit.

All signal paths shown may be differential or single-ended. For example, Q1 425 may be a differential signal including flip-flop 420 output signals Q and its complement, QBAR. In a specific embodiment, all signal paths are differential. Using differential signals reduces the jitter caused by noise from such sources as the power supply and bias lines.

Modifications to this block diagram will be readily apparent to one skilled in the art. For example, a combination of AND and OR gates may replace the XOR gates, or two latches may replace the flip-flop, making either a four latch or two flip-flop configuration.

DATA on line 405 is received by the flip-flop 420 and delay element 410. The flip-flop 420 is clocked by the CLOCK signal on lines 407 from a VCO or other clock or periodic source. On each CLOCK falling edge, the data on lines 405 is latched by the flip-flop 420 and held at the Q output as signal Q1 on line 425. The signal Q1 on line 425 is passed by latch 430 when the clock signal on line 407 is high, and latched when the clock is low. Latch 430 provides an output signal Q2 on line 435. The output signal Q2 on line 435 is passed by the second latch 440 when the clock signal on line 407 is low and latched when the clock signal is high, thereby generating signal Q3 on line 445.

Delay element 410 delays the data signal and provides an output D1 on line 415. In a specific embodiment, the delay through the delay element 410 approximately equals the clock-to-Q delay of flip-flop 420. The clock-to-Q delay for a flip-flop is the delay of the output changing in response to a clock edge. XOR gate 450 has Q1 on line 425 and D1 on line 415 as inputs. The output of XOR gate 450 is the ERROR signal on line 455. XOR gate 460 has Q2 on line 435 and Q3 on line 445 as inputs. The output of XOR gate 460 is the REFERENCE signal on line 465.

To improve performance, the delay through the delay element 410 and the clock-to-Q delays for the flip-flop 420 and latches 430 and 440 should match. Proper matching ensures that when clock edges are properly aligned to the data, the resulting ERROR and REFERENCE signals have the correct values.

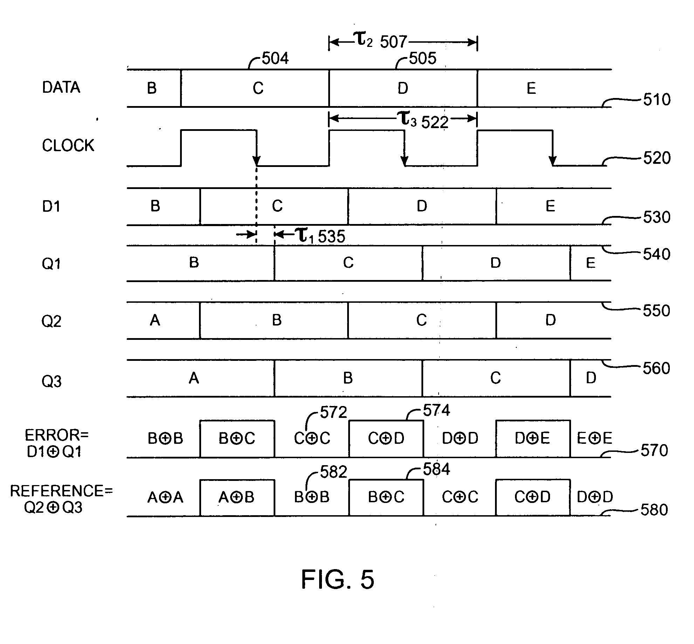

Figure 5 is a generalized timing diagram of signals in a phase detector consistent with one embodiment of the present invention, such as the block diagram of Figure 4. This and the following timing diagrams are not limited to the circuit of Figure 4 and may be generated by other circuitry consistent with the present invention. Included are inputs CLOCK 510 and DATA 520, and resulting signals D1 530, Q1 540, Q2 550, Q3 560, ERROR 570, and REFERENCE 580. Data bits, such as 504 and 505, have a duration approximately equal to one clock cycle. Each data bit may be high or low, and the DATA signal 510 may transition or remain constant from one bit to the next.

Q1 540 is DATA 510 retimed. There is typically a delay between a transition of Q1 540 as compared to the falling edges of the CLOCK 520, particularly if Q1 is generated by a flip-flop clocked by falling edges of the CLOCK signal 520 and having DATA 510 as its D input. The delay is shown here as t₁ 535. Q2 550 is Q1 540 delayed by one half clock cycle. Q3 560 is Q2 550 delayed by one half clock cycle. There may be a delay between a transition of Q2 550 and Q3 560 as compared to the corresponding edges of the CLOCK 520, particularly if Q2 and Q3 are generated by latches. Signal D1 830 is a delayed version of DATA 510.

D1 530 may be generated by delaying DATA 510 by an amount approximately equal to the delay of signal Q1 540 as compared to the CLOCK 520. ERROR 570 is generated by XORing D1 530 and Q1 540. REFERENCE 580 is generated by XORing Q2 550 and Q3 560. For reasons of clarity, in this and the following figures, the delay through the XOR gates is zero.

When transitions of the DATA signal 510 are approximately centered between clock falling edges, for some time period approximately following each falling edge of CLOCK 520, ERROR 570 is low. This is because after each falling edge of CLOCK 520, Q1 540 follows DATA 510. Accordingly, for some time period following each clock falling edge, Q1 540 and D1 530 are equal in value. For example, in the time 572 prior to the ERROR pulse 574, both D1 530 and Q1 540 are in the state C. Sometime later, DATA 510 either transitions to a new level or retains the same value. If DATA 510 changes to a new state, then D1 530 and Q1 540 become unequal, and the ERROR signal 570 is high at 574. But if data signal 510 retains its value, ERROR 570 remains low at 574. Specifically, if data bits C and D are equal, then ERROR bit 574 is low. But if data bits C and D are not equal, then ERROR bit 574 is high.

ERROR signal 570 is dependent on the phase relationship between DATA 510 and CLOCK 520 in the following manner. If data bit 504 - C - is low and data bit 505 - D - is high, then ERROR pulse 574 is high. If the DATA signal 510 advances, that is shifted to the left, then pulse 574 widens (becomes longer in duration). If the DATA signal 510 is delayed, that is shifted to the right, then pulse 574 narrows (becomes shorter in duration).

But note as above, if C and D are equal, then ERROR pulse 574 is low. Therefore, the average ERROR voltage is dependent not only on the phase error between CLOCK 520 and DATA 510, but on the data pattern of DATA 510. For this reason, the ERROR signal 570 is most meaningful in the context of REFERENCE signal 580.

This is because the REFERENCE signal's average value is also data dependent. For some time period following each falling edge of CLOCK signal 520, the REFERENCE signal 580 is low, since at each rising edge of the CLOCK 520, Q2 550 is equal to Q3 560. For example, in the time prior 582 before reference pulse 584, both Q2 550 and Q3 560 have the value B. In the next half CLOCK cycle Q2 550 has the value of the next data bit C while Q3 560 remains unchanged. Therefore, if the data bits B and C are equal then REFERENCE pulse 584 is low. But if data bits C and D are not equal, then REFERENCE bit 584 is high.

For random data, each data bit may be high or low with equal probability and may change state or remain constant at each transition, also with equal probability. Thus, each ERROR pulse, such as 574, has an equal probability of being high or low. Also each REFERENCE signal pulse, such as 584, is high an equal number of times as the ERROR probes. If the center DATA bits are aligned with the falling edge of the CLOCK 520, the ERROR signal 570 and the REFERENCE signal 580 are each low half the time and either high or low with equal probability the other half. This means that the ERROR signal 570 and REFERENCE signal 580 each have an average AC value equal to one-fourth their AC peak value.

If the data is not random, for instance if DATA 510 consists of a long string of either high or low data bits, then error pulses, such as 574, and REFERENCE pulses, such as 584 are low. The error and reference signals' average values are at a minimum. But if the data changes every bit, then each error signal pulse and each reference bit is high. Therefore, the error and reference signals are equal to one-half their peak values. Thus, the error and reference signals have the same data pattern dependency, while the error signal also tracks the phase error. This means the data dependency of ERROR signal 570 can be corrected by subtracting the REFERENCE signal 580. The difference signal between error and reference is not dependent on the data pattern, but is dependent on the phase error. This resulting signal has approximately a zero value when the edges of the data signal are aligned with the clock rising edges. As the data is delayed, the differential value becomes negative. As the data advances, the difference becomes positive.

Each data bit has a duration approximately equal to t₂ 507. The reciprocal of the data bit duration t₂ 507 is referred to as the data rate. Each clock period has a duration t₃ 522, where t₃ is approximately equal to t₂ when the loop is in a locked state. The clock frequency is the reciprocal of the duration t₃ 522. Thus, the clock frequency is approximately equal to the data rate.

Various modifications will be apparent to one skilled in the art. For example, a clock signal with a reversed polarity may be used, such that the centers data bits align with the clock rising edges.

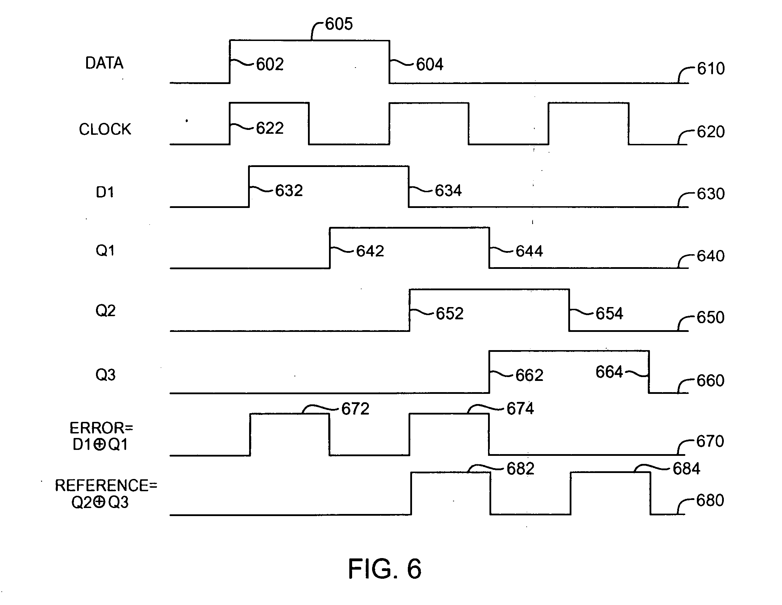

Figure 6 is a timing diagram of an embodiment of the present invention showing specific data transitions 602 and 604. Included are inputs DATA 610 and CLOCK 620, and resulting signals D1 630, Q1 640, Q2 650, Q3 660, ERROR 670, and REFERENCE 680. In this example, DATA 610 transition 605 occurs at a time corresponding to a rising edge 622 of CLOCK 620. Q1 640 is DATA signal 610 retimed and following the next falling edge of CLOCK 620. Q2 650 is Q1 640 delayed by one half a clock cycle. Q3 660 is Q2 650 delayed by one half a clock cycle. D1 630 is DATA 610 delayed in time. Again, DATA 610 may be delayed by a time approximately equal to the phase delay between a transition in Q1 640 and a falling edge of CLOCK 620 to generate D1 630. ERROR 670 is the XOR of D1 630 and Q1 640. In some applications, DATA 610 may not need to be delayed, and the DATA signal 610 may be XORed with Q1 640 to generate ERROR 670. REFERENCE 680 is the XOR between Q2 650 and Q3 660.

As can be seen in this diagram, an ERROR pulse 672 and a REFERENCE pulse 682 result from the data transmission 602. Specifically, ERROR pulse 672 begins, or goes high, at the rising edge 632 of D1 630 and returns low at the rising edge 642 of Q1 640. Similarly, REFERENCE pulse 682 begins at the edge 652 of Q2 650 and ends when Q3 660 goes high at edge 662.

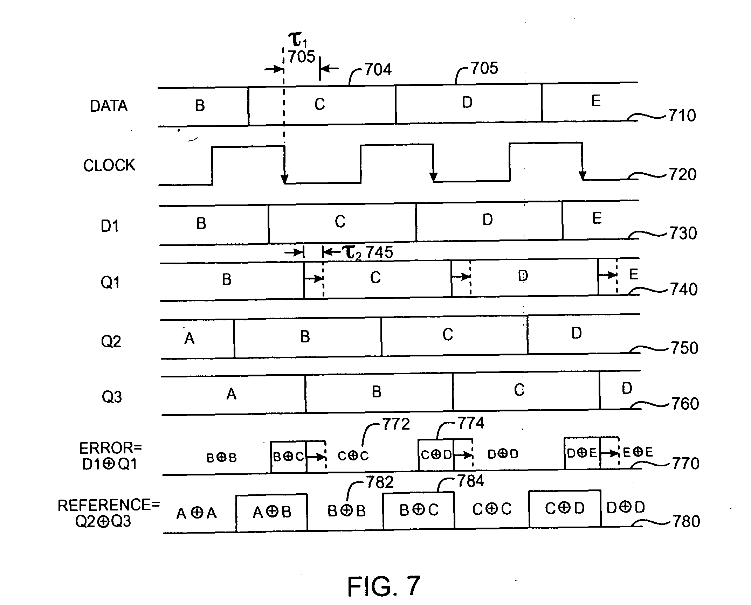

Figure 7 is a generalized timing diagram of signals in a phase detector consistent with one embodiment of the present invention, such as the block diagram of Figure 4, where the input data is delayed, or late, relative to the clock. This timing diagram is not limited to the circuit of Figure 4 and may be generated by other circuitry consistent with the present invention. Included are inputs DATA 710 and CLOCK 720, and resulting signals D1 730, Q1 740, Q2 750, Q3 760, ERROR 770, and REFERENCE 780. Data bits, such as 704 and 705, have a duration approximately equal to one clock cycle. Each data bit may be high or low, and the DATA signal 710 may transition or remain constant from one bit to the next.

Q1 740 is DATA 710 retimed. There is typically a delay between a transition of Q1 740 as compared to the falling edges of the CLOCK 720, particularly if Q1 is generated by a flip-flop clocked by falling edges of the CLOCK signal 720 and having DATA 710 as its D input. Q2 750 is Q1 730 delayed by one half clock cycle. Q3 760 is Q2 750 delayed by another half a clock cycle. There may be a delay between transitions of Q2 750 and Q3 760 as compared to the edges of CLOCK 720, particularly if Q2 and Q3 are generated by latches. Signal D1 730 is a delayed version of DATA 710.

D1 730 may be generated by delaying DATA 710 by an amount approximately equal to the delay of signal Q1 740 as compared to the CLOCK 720. ERROR 770 is generated by XORing D1 730 and Q1 740. REFERENCE 780 is generated by XORing Q2 750 and Q3 760.

In this timing diagram, DATA 710 is delayed or shifted to the right by a time t₁, 705 relative to the falling edges of CLOCK 920. A consequence of this is that D1 730 is delayed in time. Since ERROR pulses begin at transitions in D1, the ERROR pulses begin later. Specifically, ERROR pulse 774 starts later than ERROR pulse 574 in Figure 5. Again, Q1 740 is DATA 710 retimed to CLOCK 710, so Q1 740 is aligned to Q1 540 in Figure 5. Since the ERROR pulse 774 ends when Q1 740 transitions, pulse 774 ends at the same relative time as pulse 574. Accordingly, ERROR pulse 774 starts later and ends at the same relative time as ERROR pulse 574, and is thus narrower.

ERROR signal 770 is dependent on the phase relationship between DATA 710 and CLOCK 720 in the following manner. If data bit 704 - C - is low and data bit 705 - D - is high, then ERROR pulse 774 is high. If the DATA signal 710 is delayed, that is shifted to the right, then pulse 774 in the ERROR signal 770 narrows (becomes shorter in duration).

If the data is late, the setup time of a flip-flop having DATA 710 as its input and CLOCK 720 as its clock is reduced. At some point, this reduced setup time translates to an increase in the clock-to-Q delay of the flip-flop. This excess delay is shown as t₂ 745. Again, one reason for this increased delay is a reduced amplitude of the signal at the input stage of the flop-flop, meaning that the second stage has a reduced drive. This reduced drive leads to an increase in the transition time. Again, this may be referred to as amplitude modulation―phase modulation.

This increase in clock-to-Q delay widens the ERROR pulse 774 by a similar amount. But the REFERENCE pulse 784 is not similarly effected, since it is not determined by Q1. Rather, the REFERENCE pulses are determined by Q2 750 and Q3 760. Q2 has Q1 as its input, but it has a half a clock cycle setup time. Though this setup time is reduced by the increase in Q1 clock-to-Q, it is typically sufficient such that the clock-to-Q of Q2 does not change.

Accordingly, though the ERROR pulse does change in duration with an increasing clock-to-Q for Q1, the REFERENCE pulse does not. This improved immunity extends the linear and monotonic ranges of the phase detector, allowing for greater adjustment of the phase between the incoming data and VCO clock.

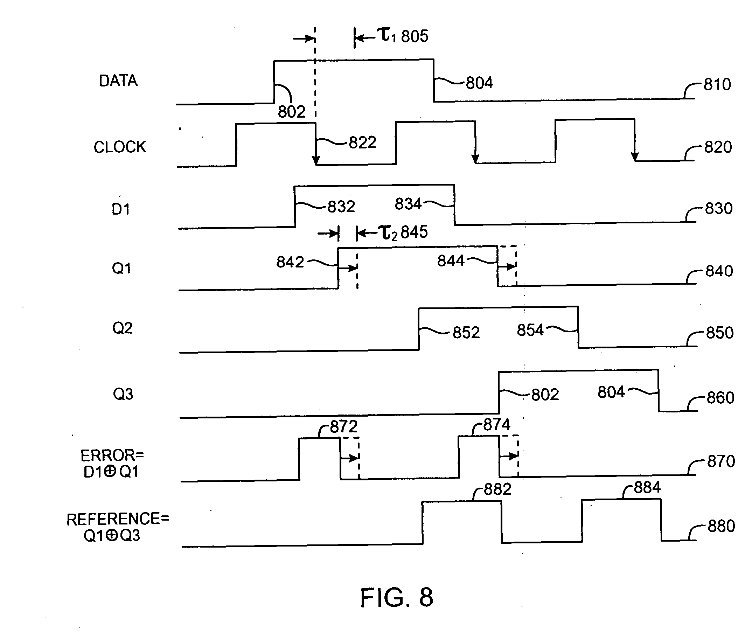

Figure 8 shows this for specific DATA transitions 802 and 804. Shown is a timing diagram with a phase error t₁ 805 introduced between a data center 805 and a CLOCK falling edge 822. Included are inputs DATA 810 and CLOCK 820, and resulting signals D1 830, Q1 840, Q2 850, Q3 860, ERROR 870, and REFERENCE 880. Again, the transition 802 in DATA 810 results in a pulse in ERROR waveform 870, specifically 872, and a REFERENCE pulse 882. But this time, since the DATA 810 has been delayed, ERROR pulse 872 is narrower than the corresponding pulse 672 in Figure 6. Accordingly, the average value of the ERROR signal 870 is lower than the average value of the ERROR signal 670 in Figure 6. But again, since the REFERENCE pulse 870 is defined by signals timed to the falling and rising edges of the CLOCK 820, its width does not change as compared to REFERENCE pulse 680 in Figure 6. Therefore, the difference between the ERROR signal and the REFERENCE signal has changed, and this difference signal can be used to correct for the phase error between DATA transitions such as 802 and the rising edges of the CLOCK 820.

Again, if the data is late, the setup time of a flip-flop having DATA 810 as its input and CLOCK 820 as its clock is reduced. At some point, this reduced setup time translates to an increase in the clock-to-Q delay of the flip-flop. This excess delay is shown as t₂ 845. This increase in clock-to-Q delay widens the ERROR pulse 872 by a similar amount. But the REFERENCE pulse 882 is not similarly effected, since it is not determined by Q1. Rather, the REFERENCE pulse 882 is determined by the rising edge 852 of Q2 850 and the rising edge 862 of Q3 860. Accordingly, though the ERROR pulse 872 does change in duration with an increasing clock-to-Q for Q1, the REFERENCE pulse 882 does not. Again, this improved immunity extends the linear and monotonic ranges of the phase detector, allowing for greater adjustment of the phase between the incoming data and VCO clock.

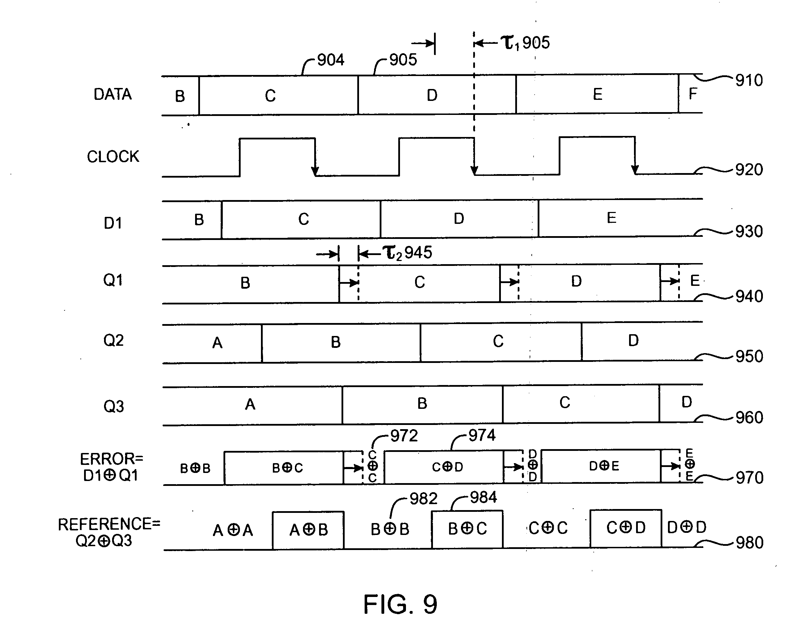

Figure 9 is a generalized timing diagram of signals in a phase detector consistent with one embodiment of the present invention, such as the block diagram of Figure 4, where the data is advanced relative to the clock. But this timing diagram is not limited to the circuit of Figure 4 and may be generated by other circuitry consistent with the present invention. Included are inputs DATA 910 and CLOCK 920, and resulting signals D1 930, Q1 940, Q2 950, Q3 960, ERROR 970, and REFERENCE 980. Data bits, such as 904 and 905, have a duration approximately equal to one clock cycle. Each data bit may be high or low, and the DATA signal 910 may transition or remain constant from one bit to the next.

Q1 940 is DATA 910 retimed. There is typically delay between a transition of Q1 940 as compared to the falling edges of the CLOCK 920, particularly if Q1 is generated by a flip-flop clocked by falling edges of the CLOCK signal 920 and having DATA 910 as its D input. Q2 950 is Q1 940 delayed by one half clock cycle. There may be a delay between transitions of Q2 and Q3 940 as compared to the edges of the CLOCK 920, particularly if Q2 and Q3 are generated by latches. Signal D1 930 is a delayed version of DATA 910.

D1 930 may be generated by delaying DATA 910 by an amount approximately equal to the delay of signal Q1 940 as compared to the CLOCK 920. ERROR 970 is generated by XORing D1 930 and Q1 940. REFERENCE 980 is generated by XORing Q2 950 and Q3 960.

In this timing diagram, DATA 910 is advanced or shifted to the left by a time t₁ 905 relative to the falling edges of CLOCK 920. A consequence of this is that D1 930 is also advanced. Since ERROR pulses begin at transitions in D1, the ERROR pulses begin early. Specifically, ERROR pulse 974 starts earlier than ERROR pulse 574 in Figure 5. Again, Q1 is DATA 910 retimed to CLOCK 920, so Q1 940 is aligned to Q1 540 in Figure 5. Since the ERROR pulse 974 ends when Q1 940 transitions, pulse 974 ends at the same relative time as pulse 574. Accordingly, ERROR pulse 974 starts earlier and ends at the same relative time as ERROR pulse 574, and is thus wider.

ERROR signal 970 is dependent on the phase relationship between DATA 910 and CLOCK 920 in the following manner. If data bit 904 - C - is low and data bit 905 - D - is high, then ERROR pulse 974 is high. If the DATA signal 910 is advanced, that is shifted to the left, then pulse 974 in the ERROR signal 970 widens (becomes longer in duration).

If the data is early, the hold time of a flip-flop having DATA 910 as its input and CLOCK 920 as its clock is reduced. At some point, this reduced hold time translates to an increase in the clock-to-Q delay of the flip-flop. This excess delay is shown as t₂ 945. This increase in clock-to-Q delay widens the ERROR pulse 972 by a similar amount. But as before, the REFERENCE pulse 982 is not similarly effected, since it is not determined by Q1. Rather, the REFERENCE pulse 982 is determined by the rising edge 952 of Q2 950 and the rising edge 962 of Q3 960. Accordingly, though the ERROR pulse 972 does change in duration with an increasing clock-to-Q for Q1, the REFERENCE pulse 982 does not. Again, this improved immunity extends the linear and monotonic ranges of the phase detector, allowing for greater adjustment of the phase between the incoming data and VCO clock.

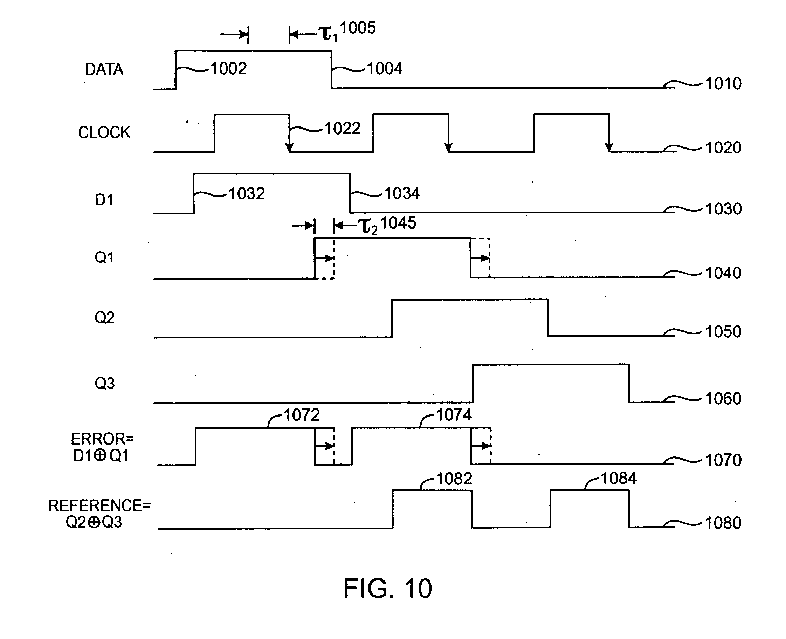

Figure 10 shows this for specific DATA transitions 1002 and 1004. Shown is a timing diagram with a phase error t₁ 1005 introduced between a data transition 1002 and a CLOCK rising edge 1022. Included are inputs DATA 1010 and CLOCK 1020, and resulting signals D1 1030, Q1 1040, Q2 1050, Q3 1060, ERROR 1070, and REFERENCE 1080. The transition 1002 in DATA 1010 results in a pulse in ERROR waveform 1070, specifically 1072, and a REFERENCE bit 1082. But this time, since the DATA 1010 has been advanced, ERROR pulse 1072 is wider than the corresponding pulse 674 in Figure 6. Specifically, ERROR pulse 1072 is wider by an amount shown here as t₁ 1005. Accordingly, the average value of ERROR signal 1070 is higher than the average value of ERROR signal 670 in Figure 6. But again, since the REFERENCE pulse 1082 is defined by signals timed to the falling and rising edges of the CLOCK 1020, its width does not change as compared to REFERENCE pulse 682 in Figure 6. Therefore, the difference between the ERROR signal and the REFERENCE signal has changed, and this difference signal is used to correct for the phase error between DATA transitions such as 1002 and the rising edges of the CLOCK 1020.

Again, if the data is early, the hold time of a flip-flop having DATA 810 as its input and CLOCK 820 as its clock is reduced. At some point, this reduced setup time translates to an increase in the clock-to-Q delay of the flip-flop. This excess delay is shown as t₂ 1045. This increase in clock-to-Q delay widens the ERROR pulse 1072 by a similar amount. But the REFERENCE pulse 1082 is not similarly effected, since it is not determined by Q1. Rather, the REFERENCE pulse 1082 is determined by the rising edge 1052 of Q2 1050 and the rising edge 1062 of Q3 1060. Accordingly, though the ERROR pulse 1072 does change in duration with an increasing clock-to-Q for Q1, the REFERENCE pulse 1082 does not. Again, this improved immunity extends the linear and monotonic ranges of the phase detector, allowing for greater adjustment of the phase between the incoming data and VCO clock.

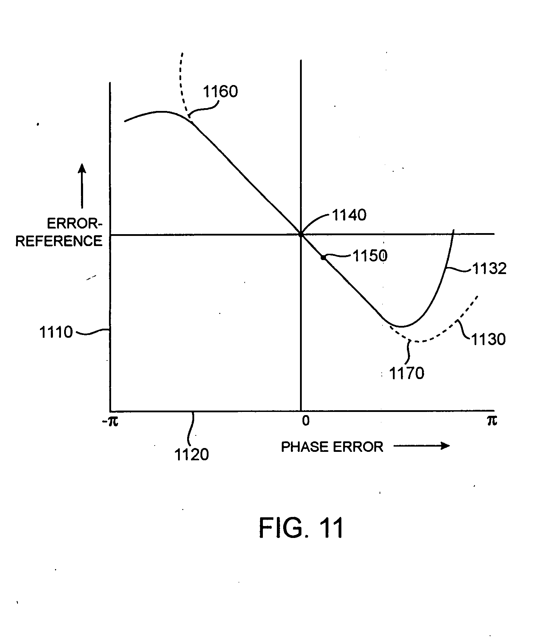

Figure 11 is a plot illustrating the difference voltage between the ERROR and REFERENCE signals for a phase detector consistent with an embodiment of the present invention as a function of a phase difference between a reference clock and VCO clock signal. The difference voltage between the ERROR and REFERENCE signals, the gain of the phase detector, is plotted as curve 1130 along a Y-axis 1110 as a function of the phase error between the received data and clock signal from the VCO on X-axis 1120. For comparison purposes, the gain of a convention phase detector is shown as curve 1132.

As can be seen, the phase detector operates over an extended monotonic range between inflection points 1160 and 1170. Typically, when the loop is a locked, the phase detector operates at or near a zero phase error at point 1140. Again, an offset current may be applied to the charge pump or loop filter in the phase locked loop, thus shifting the operating point from a zero phase error, for example to point 1150. Since the range of curve 1130 is greater than 1132, the phase detector operating point can be shifted a greater amount, while still allowing the phase-locked loop to function properly.

Again, the reason that the linear and monotonic ranges are increased is that the REFERENCE signal is not degraded by an increase in the clock-to-Q delay of the flip-flop or other storage device that receives the incoming data signal. Again, this is done by generating the REFERENCE signal using the first and second latches 430 and 440 in Figure 4, rather than the output of the flip-flop 410.

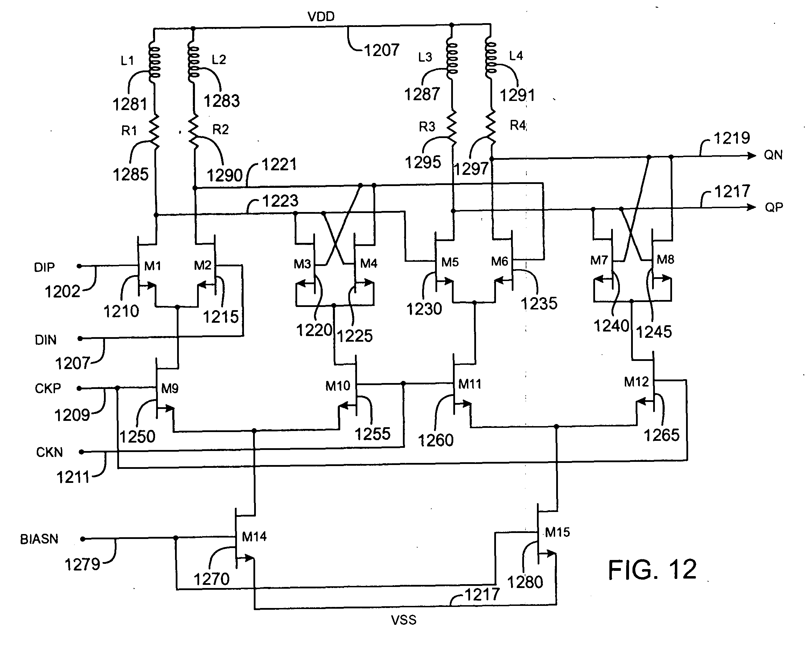

Figure 12 is a schematic for an exemplary implementation of a negative-edge triggered flip-flop based on current-controlled CMOS (C3MOS) logic with inductive broadbanding, which may be used as the flip-flop 420 in Figure 4. The concept of C3MOS logic with inductive broadbanding is described in greater detail in commonly-assigned U.S. patent application number 09/610,905, filed July 6, 2000, entitled "Current-Controlled CMOS Circuits With Inductive Broadbanding", by Michael Green, which is hereby incorporated by reference. One skilled in the art appreciates that other flip-flops can be used, for example a bipolar flip-flop, a flip-flop made of GaAs on silicon, or other types of flip-flops could be used. Another embodiment of a flip-flop is described in commonly-assigned U.S. patent application number 09/784,419, filed February 15, 2001, entitled "Linear Full-Rate Phase Detector & Clock & Data Recovery Circuit", by Jun Cao, which is hereby incorporated by reference. Alternately, as with all the included schematics, current source loads, p-channel loads operating in their triode regions, or source follower outputs could be used. N-channel metal oxide semiconductor field effect transistors (MOSFET, or NMOS) are shown, but alternately, as with all the included schematics, p-channel (PMOS) devices could be used.

The flip-flop is made up of two latches, a master and a slave, in series. In this example, a master latch includes input differential pair M1 1210 and M2 1215, latching devices M3 1220 and M4 1225, clock pair M9 1250 and M10 1255, current source M14 1270, and series combination loads L1 1281 and R1 1285, and L2 1283 and R2 1290. A slave latch includes input differential pair M5 1230 and M6 1235, latching pair M7 1240 and M8 1245, clock pair M11 1260 and M12 1265, current source M15, 1280, and series combination loads L3 1287 and R3 1295, and L4 1291 and R4 1297. Data inputs DIP and DIN are received on lines 1202 and 1207, clock inputs CKP and CKN are received on lines 1209 and 1211, a bias voltage BIASN is received on line 1279, and outputs QP (true) and QN (complementary) are provided on lines 1217 and 1219.

The power supplies are shown here as VDD on line 1207 and VSS on line 1217. The VDD and VSS voltages for this and all the included figures are typically equal, but are not so limited. VDD may be a positive supply above ground. For example, VDD may be 5.0, 3.3, 2.5, 1,8, or other supply voltage. Alternately, VDD may be ground. VSS may be ground. Alternately, VSS may be below ground, such as -1.8, -2.5, -3.3, -5.0, or other voltage. In other embodiments, other voltages may be used.

Bias voltage BIASN is applied to the gates of M14 1270 and M15 1280 relative to their sources, which are coupled to line 1217. This bias voltage generates currents in the drains of M14 1270 and M15 1280. When the clock signal is high, the signal level of CKP on line 1209 is higher than the signal level of CKN on line 1211, and the master latch is in the pass mode and the slave latch is in the latched mode. Specifically, the drain current of M14 1270 is passed through M9 1250 to the input differential pair M1 1210 and M2 1215, and the drain current of M15 passes through device M12 1265 to the latching pair M7 1240 and M8 1245. If the voltage at D is high, the voltage on line DIP 1202 is higher than the voltage DIN on line 1207 and the drain current of M9 flows through device M1 1210 into load resistor R1 1285 and load inductor L1 1281, thereby lowering the voltage at the drain of M1 1210. The device M2 1215 is off and the voltage at its drain is high. If the voltage at QN on line 1219 is high, the drain current from M12 1265 passes through device M7 1240 across the load resistor R3 1295 and load inductor L3 1287, and the signal QP on line 1217 is low.

When the clock signal is low, the signal level of CKN on line 1211 is higher than the signal CKP on line 1209 and the master is latched and the slave passes data. The drain current of M14 1270 passes through M10 1255, and the drain current of M15 1280 passes through device M11 1260. If the signal level at DIP had previously been high such that the voltage at the drain of M1 1210 is low, the drain current of M10 1255 passes through device M3 1220 across the load resistor R1 1285 and load inductor L1 1281, thus keeping the voltage at the drain of M1 1210 low. Furthermore, latch pair M7 1240 and M8 1245 are off, and input pair M5 1230 and M6 1235 are on, and follow the data signal provided by latch pair M3 1220 and M4 1225. In this example, M6 1235 is on, and conducts the drain current of M11 1260 to the load resistor R4 1297 and load inductor L4 1291, pulling down QN on line 1219, and allowing QP on 1217 to return high. Therefore, after each clock falling edge, the signal voltage CKN on line 1211 exceeds in the signal voltage CKP on line 1209, and the data at the input port DIP 1202 and DIN 1207 is latched by the master latch and output by the slave latch on lines QP 1217 and QN 1219.

If this flip-flop is used for the flip-flop in Figure 4, the following should be noted. If the signals are differential, DIP, CKP and QP correspond to the D, clock, and Q ports of the flip-flop in Figure 4. If single-ended signals are used, DIN and CKN are coupled to bias voltages that preferably have a DC voltage equal to the average signal voltage at DIP and CKP. This circuit can be changed into a positive-edge triggered flip-flop by reversing the CKP and CKN lines.

The clock-to-Q delay for this circuit can be described qualitatively by way of an example. Let the initial conditions be such that the clock input CKP is high, the output voltage QP on line 1217 is low, and the D input DIP is high. The drain current of M15 1280 flows through M12 1265 through M7 1240 into the load resistor R3 1295 and load inductor L3 1287. Also, the drain current of M14 1270 flows through M9 1250, and through device M1 1210 through the load resistor R1 1285 and load inductor 1281. Accordingly, the voltage on line 1223 is lower than the voltage on line 1221. After the following edge of the clock signal, CKN on line 1211 is higher than CKP on line 1209. Thus, the drain current of M15 1280 switches from M12 1265 to M11 1260. M11 1260 directs current through M6 1235, where it flows through load resistor R4 1297 and load inductor L4 1291. QP on line 1217 goes high and QN on line 1219 goes low. Thus, the clock-to-Q delay is the delay time it takes for M11 1260 to turn on and conduct the current of M15 1280, plus the time required for M6 to turn on and conduct current thereby changing voltage QN on line 1219 and QP on line 1217.

As the setup or hold times decrease for this flip-flop, the differential signal level at the drains of M1 1210 and M2 1215 are reduced. This means that there is less drive available to switch M5 1230 and M6 1235. As a result, these propagation delay through the differential pair M5 1230 and M6 1235 is increased. Accordingly, the clock-to-Q delay is increased.

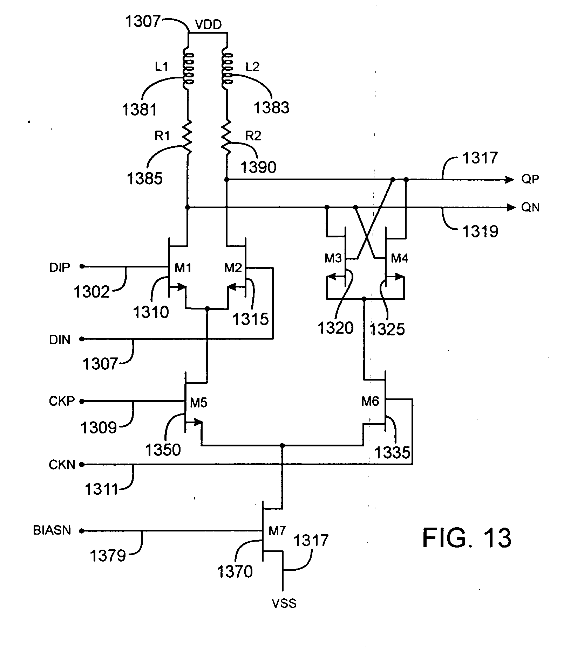

Figure 13 is a schematic of a latch with inductive broadbanding that may be used as latches 430 and 440 in Figure 4. Alternately, other types of latches may be used, for example cross coupled logic gates may be used. Included are input differential pair M1 1310 and M2 1315, latching pair M3 1320 and M4 1325, clock pair M5 1350 and M6 1355, current source M7 1370, and series loads of inductor L1 1381 and resistor R1 1385, and inductor L2 1338 and resistor R2 1390. Data inputs DIP and DIN are received on lines 1302 and 1307, clock inputs CKP and CKN are received on lines 1309 and 1311, bias voltage BIASN is received on line 1379, and outputs QP (true) and QN (complementary) are provided on lines 1317 and 1319.

The bias voltage BIASN is applied on line 1379 to the gate of M7 1370 relative to its source that is coupled to line 1317. When the clock input signal is high, the signal voltage CKP on line 1309 is higher than the signal voltage CKN on 1311 and the drain current of M7 1370 flows through M5 1350 to the input differential pair M1 1310 and M2 1315. When the D input is high, the signal voltage DIP on line 1302 is higher than the signal voltage DIN on line 1307 and the drain current from M5 1350 flows through device M1 1310 through load inductor L1 1381 and resistor R1 1385 pulling the signal voltage QN on line 1319 low and allowing the signal voltage QP on line 1317 to go high. When the clock signal goes low, the voltage CKN on line 1311 is high and signal voltage CKP on line 1309 is low. Thus, device M6 directs the drain current from M7 1370 to the latching pair M3 1320 and M4 1325, which latch the data at the QP 1317 and QN 1319 outputs.

If this latch is used as the latch in Figure 4, the following should be noted. If the signals are differential, DIP, CKP and QP correspond to the D, clock, and Q ports of the latch in Figure 4. If single-ended signals are used, DIN and CKN are coupled to bias voltages that preferably have a DC voltage equal to the average signal voltage at DIP and CKP.

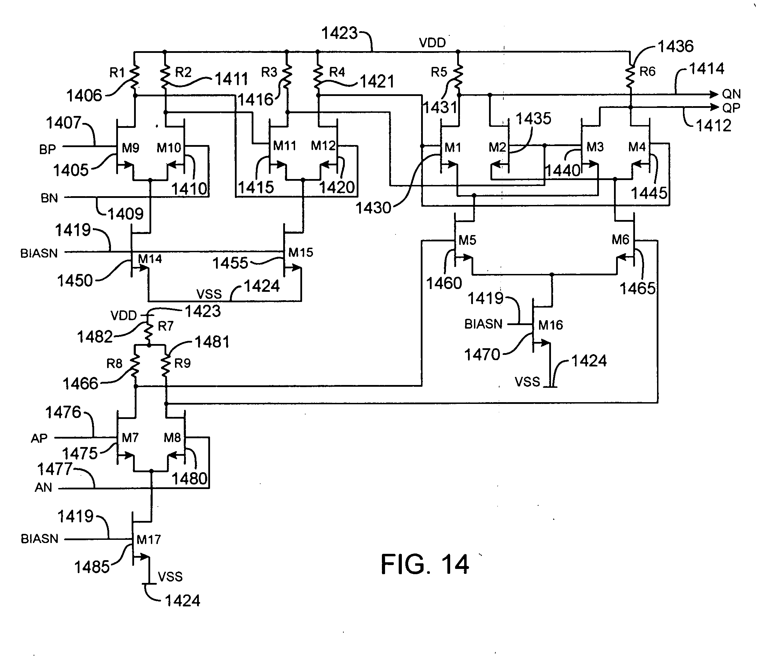

Figure 14 and is an exemplary high speed XOR gate implemented using C3MOS logic that may be used with various embodiments of the present invention. For example, this XOR gate may be used as XOR gates 340 and 350 in Figure 3. Alternately, other XOR gates may be used, such as a bipolar XOR gate. Included are B input buffers M9 1405 and M10 1410, and M11 1415 and M12 1420, and A input buffer M7 1475 and M8 1480. An XOR core made up of devices M1 1430, M2 1435, M3 1440, M4 1445, M5 1460, and M6 1465, is also shown. Inputs AP and AN are received on lines 1476 and 1477, inputs BP and BN are received on lines 1407 and 1409, bias voltage BIASN is received on line 1419, and QP (true) and QN(complementary) outputs are provided on lines 1412 and 1414. Current sources M14 1450, M15 1455, M16 1470, and M17 1485, are biased with BIASN such that a current is produced in their drains. The BIASN voltage applied to all these devices may be equal to each other. Alternately, different BIASN voltages may be used for the buffers and the core. Further, the buffers may have differing BIASN voltages. Also, this BIASN voltage may the same or different voltage as the BIASN voltage in Figures 12 and 13.

Signals at the A input steer the drain currents of M16 1470 through either M5 1460 or M6 1465. The signal at the B input steers the current to the load resistors thereby generating voltage outputs at QP and QN on lines 1412 and 1414. The connections are such that QP is high when the signal at either, but not both, the A input and the B input are high. To match the delay from input to output, two buffers are used in the B path, and one buffer is used in the A path. This is because the A input steers the lower devices M5 and M6, which then drive upper devices M1 through M4. But the B input drives devices M1 to M4 directly. Thus, to compensate for the delay through M5 1460 and M6 1465, an extra buffer is inserted in the B path. Resistor R7 1482 lowers the common mode voltage of the output of the A input buffer, which improves the transient response of the lower differential pair M5 1460 and M6 1465.

An alternate embodiment for an XOR gate can be found in commonly assigned U.S. patent application number 09/782,687, filed February 12, 2001, entitled "Linear Half-Rate Phase Detector and Clock and Data Recovery Circuit," by Jafar Savoj, which is hereby incorporated by reference. Also, other architectures which may be used to implement some of the circuits herein can be found in commonly assigned U.S. patent application number 09/484,856, filed January 18, 2000, entitled "C3MOS Logic Family," by Armond Hairapetian, which is hereby incorporated by reference.

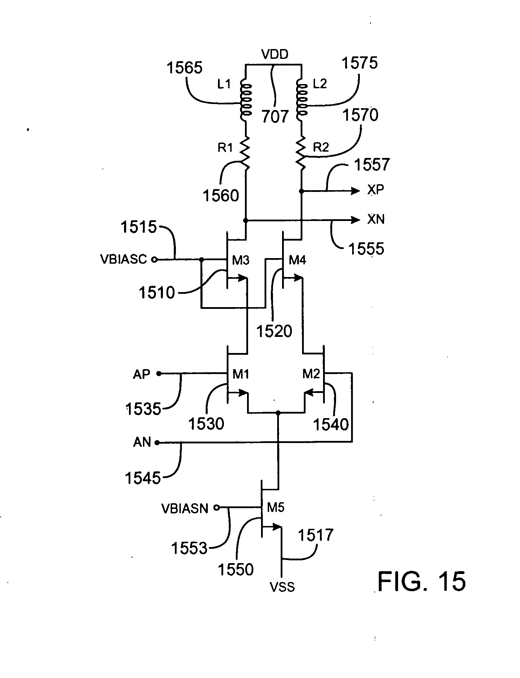

Figure 15 is a schematic of an exemplary circuit implementation for a delay circuit with inductive broadbanding that may be used as delay element 410 in Figure 4. One skilled in the art appreciates that this delay block could be designed several different ways. For example, an RC network could be used. Included are input pair devices M1 1530 and M2 1540, cascode devices M3 1510 and M4 1520, series loads of inductor L1 1565 and R1 1560, and L2 1575 and R2 1570, and current source device M5 1550. Inputs AP and AN are received on lines 1535 and 1545, bias voltages BIASN and VBIASC are received on lines 1553 and 1515, and outputs XP (true) and XN (complementary) are provided on lines 1557 and 1555.

VBIASC may be tied to VDD or other appropriate bias point. An input signal is applied at the A port, AP on line 1535 and AN on line 1545, to the first input pair M1 1530 and M2 1540. Bias voltage BIASN is applied to the gate of M5 relative to its source terminal that is coupled to line 1517. BIASN may be the same bias line as was used in Figure 4A or it may be a different bias voltage. This voltage generates a current in the drain of M5 1550. If the voltage at the A input port is high, the signal voltage AP on line 1535 is higher than the signal level of AN on line 1545 and the drain current of M5 1550 flows through the device M1 1530, through cascode device M3 1510, to the load resistor R1 1560 and load inductor L1 1565, pulling the voltage XN on line 1555 low. Conversely, if the signal at the A port is low, the voltage signal at AP is lower than the signal level at AN and the drain current of M5 1530 flows through device M2 1540, through cascode device M4 1520, to the load resistor R2 1570 and load inductor L2 1575, pulling output XP on line 1557 low. In this way, a signal applied to input port A on lines 1535 and 1545 results in a delayed signal appearing at lines at XP 1557 and XN 1555.

In a specific embodiment, die area is conserved by not including inductors L1 1565 and L2 1575 in the loads. Rather, the load resistors R1 1560 and R2 1570 connect directly between VDD line 1507 and the drains of M3 1510 and M4 1520. In this embodiment, the width of device M5 1550, and thus its drain current is decreased, and the value of resistors R1 1560 and R2 1570 are increased relative to the flip-flop and latch such that the delay through this block matches the clock-to-Q delays of the storage elements. Thus, the voltage swing of the delay block is substantially equal to the latch and flip-flop. In this way, sufficient matching may be retained while saving the area that two inductors would otherwise consume.

If this delay element is used as the delay element in Figure 4, the following should be noted. If the signals are differential, AP and XP correspond to the A and X ports of the latch in Figure 4. If single-ended signals are used, AN is coupled to a bias voltage that preferably has a DC voltage equal to the average signal voltage at AP.

The foregoing description of specific embodiments of the invention has been presented for the purposes of illustration and description. It is not intended to be exhaustive or to limit the invention to the precise form described, and many modifications and variations are possible in light of the teaching above. The embodiments were chosen and described in order to best explain the principles of the invention and its practical applications to thereby enable others skilled in the art to best utilize the invention in various embodiments and with various modifications as are suited to the particular use contemplated.

## Claims

1. A method of recovering data from a data signal comprising:
receiving a clock signal having a first clock frequency, and alternating between a first level and a second level;
receiving the data signal having a first data rate, the first data rate being substantially equal to the first clock frequency;
providing a first signal by storing the data signal when the clock signal alternates from the first level to the second level;
providing a second signal by passing the first signal when the clock signal is at the first level, and storing the first signal when the clock signal is at the second level;
providing a third signal by storing the second signal when the clock signal is at the first level, and passing the second signal when the clock signal is at the second level;
providing a fourth signal by delaying the data signal an amount of time; providing an error signal by combining the first signal and the fourth signal; and
providing a reference signal by combining the second signal and the third signal.

2. The method of claim 1 further comprising:
applying the error signal and the reference signal to a loop filter to generate a loop filter output.

3. The method of claim 1 wherein first signal is provided by a flip-flop, and the second and third signals are provided by latches.

4. The method of claim 3 wherein the providing an error signal and providing a reference signal are done by exclusive-OR gates.

5. The method of claim 3 wherein the delay is approximately equal to a clock-to-Q delay of the flip-flop.

6. A phase detector for recovering data from a data signal comprising:
a first storage device configured to receive and store the data signal and to generate a first signal;
a second storage device configured to receive and store the first signal and to generate a second signal;
a third storage device configured to receive and store the second signal and to generate a third signal;
a delay block configured to receive and delay the data signal and to generate a fourth signal;
a first logic circuit configured to combine the first and fourth signals; and
a second logic circuit configured to combine the second and third signals.

7. The phase detector of claim 6 wherein the first storage device is a flip-flop and the second and third storage devices are latches.

8. The phase detector of claim 7 wherein the flip-flop and the latches receive a clock signal, the clock signal having first edges from a first level to a second level and second edges from the second level to the first level.

9. The phase detector of claim 8 wherein the flip-flop stores the received data signal on the first edges of the clock.

10. The phase detector of claim 9 wherein the first edges are falling edges and the second edges are rising edges.

11. The phase detector of claim 6 wherein a delay through the delay block is approximately equal to a clock-to-Q delay of the flip-flop.

12. A phase detector for recovering data from a received data signal comprising:
a flip-flop having a data input coupled to a data input port, and a clock input coupled to a clock port;
a first latch having a data input coupled an output of the first flip-flop, and a clock input coupled to the clock port;
a second latch having a data input coupled to an output of the first latch, and a clock input coupled to the clock port;
a delay element having an input coupled to the data input port;
a first logic circuit having a first input coupled to the output of the flip-flop and a second input coupled to an output of the delay element; and
a second logic circuit having a first input coupled to the output of the first latch and a second input coupled to an output of the second latch.

13. The phase detector of claim 12 wherein the first data input port is configured to receive a differential signal.

14. The phase detector of claim 13 wherein the first clock port is configured to receive a differential signal.

15. The phase detector of claim 12 wherein the first logic circuit and the second logic circuit are exclusive-OR gates.

16. The phase detector of claim 12 wherein the first logic circuit and the second logic circuit perform an exclusive-OR function.

17. The phase detector of claim 12 wherein the first logic circuit provides a reference signal, and the second logic circuit provides an error signal.

18. An optical receiver comprising the phase detector of claim 12.

19. An optical transceiver comprising:
an optical transmitter; and
the optical receiver of claim 18 coupled to the optical transmitter.

20. A system for receiving and transmitting optical signals comprising:
a light emitting diode, configured to transmit optical signals;
a transmitter coupled to the light emitting diode;
a photo-diode, configured to receive optical signals;
a receive amplifier coupled to the photo-diode; and
the phase detector of claim 12 coupled to the receive amplifier.
